(19) Europäisches Patentamt / European Patent Office / Office européen des brevets

(11) **EP 1 630 848 B1**

(12) **EUROPÄISCHE PATENTSCHRIFT**

(45) Veröffentlichungstag und Bekanntmachung des Hinweises auf die Patenterteilung:
**29.10.2008 Patentblatt 2008/44**

(51) Int Cl.:
*H01J 37/32* (2006.01)   *C23C 16/511* (2006.01)
*C23C 16/52* (2006.01)   *C23C 16/04* (2006.01)
*C23C 16/02* (2006.01)   *C23C 16/40* (2006.01)

(21) Anmeldenummer: **05018452.2**

(22) Anmeldetag: **25.08.2005**

(54) **Verfahren und Vorrichtung zur Plasmabeschichtung von Werkstücken mit spektraler Auswertung der Prozessparameter**

Process and apparatus for plasma coating of workpieces with spectral evaluation of process parameters

Procédé et dispositif pour le revetement de pièces par plasma dans lequel les parametres du procédé sont évalués par mesures spectrales

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **31.08.2004 DE 102004042431**

(43) Veröffentlichungstag der Anmeldung:
**01.03.2006 Patentblatt 2006/09**

(73) Patentinhaber: **Schott AG**
**55122 Mainz (DE)**

(72) Erfinder:
• **Behle, Stephan, Dr.**
**55239 Gau-Odernheim (DE)**

• **Lüttringhaus-Henkel, Andreas**
**64289 Darmstadt (DE)**
• **Eimann, Peter**
**55270 Schwabenheim (DE)**
• **Klein, Jürgen, Dr.**
**55127 Mainz (DE)**

(74) Vertreter: **Blumbach - Zinngrebe**
**Patentanwälte**
**Alexandrastrasse 5**
**65187 Wiesbaden (DE)**

(56) Entgegenhaltungen:
**US-A- 6 117 243        US-A1- 2003 190 761**

**Beschreibung**

Die Erfindung betrifft allgemein die Plasmabeschichtung von Behältern, insbesondere betrifft die Erfindung die spektroskopische Kontrolle des Beschichtungsprozesses.

Es ist bekannt, Behälter, wie insbesondere Flaschen mit Barriereschichten zu versehen. Diese Barriereschichten werden unter anderem mit chemischer oder physikalischer Dampfphasenabscheidung hergestellt. Mit diesen Verfahren können vergleichsweise dünne Schichten mit hoher Barrierewirkung erzeugt werden.

Als Verfahren zur chemischen Dampfphasenabscheidung hat sich insbesondere die plasmaunterstützte oder plasmainduzierte Dampfphasenabscheidung bewährt, bei welcher in einem Prozeßgas mittels elektromagnetischer Energie ein Plasma gezündet und die sich im Plasma bildenden Reaktionsprodukte als Schicht auf dem Behälter niederschlagen.

Dieses Verfahren ist unter anderem besonders für eine kostengünstige Beschichtung großer Mengen von Werkstücken, wie etwa zur Beschichtung von Kunststoffflaschen zur Verbesserung der Barriereeigenschaften geeignet.

Aus der US-A-6,117,243 ist eine CVD-Anlage zur Innenbeschichtung hohler Werkstücke bekannt, welche eine Beschichtungskammer, eine Mikrowellen-Plasmazündundungs-Einrichtung, eine Gaszuführung und einen optischen Detektor aufweist, wobei die Mikrowellen-Plasmazündundungs-Einrichtung und der optische Detektor mit einer Kontroll- und Analyseeinrichtung verbunden sind, welche die Zeitkorrelation der Zündpulse und Lichtpulse und die Intensität zumindest einer Emissionslinie des Plasmas analysiert.

Aus der US 2003/90761 A1 ist weiterhin ein Verfahren und System bekannt, bei welchem ein Halbleiter-Herstellungsprozess spektroskopisch gesteuert und kontrolliert wird. Dabei wird bei einer Vielzahl von Abläufen der Herstellung jeweils zumindest ein Prozeßparameter ausgehend von einem Zielwert geändert und spektrale Daten des vom Plasma während der Abläufe emittierten Lichts gesammelt.

Es besteht bei der Beschichtung großer Mengen von Werkstücken Bedarf daran, den Prozeßablauf einfach überwachen und fehlerhafte Beschichtungen oder Werkstücke schnell erkennen zu können.

Der Erfindung liegt demgemäß die Aufgabe zugrunde, eine schnelle und einfache Überwachung des Beschichtungsablauf zu ermöglichen und damit die Qualität plasmabeschichteter Werkstücke zu verbessern.

Diese Aufgabe wird bereits in höchst überraschend einfacher Weise durch ein Verfahren, sowie eine Beschichtungsanlage gemäß den unabhängigen Ansprüchen gelöst. Vorteilhafte Ausgestaltungen und Weiterbildungen der Erfindung sind in den Unteransprüchen angegeben.

Demgemäß sieht die Erfindung ein Verfahren zur Beschichtung von Werkstücken mittels plasmainduzierter chemischer Dampfphasenabscheidung vor, bei welchem ein Prozeßgas in eine Beschichtungskammer eingeleitet und mittels elektromagnetischer Energie ein Plasma in zumindest einem an das Werkstück angrenzenden Bereich der Beschichtungskammer gezündet wird, in welchem das Prozeßgas vorhanden ist, wobei der Beschichtungsvorgang anhand zumindest eines gemessenen spektralen Parameters des Plasmas kontrolliert und das Werkstück bei einer Abweichung von einem Sollbereich des Parameters das Werkstück aussortiert wird.

Unter elektromagnetischer Energie, welche in die Beschichtungskammer geleitet wird, werden im Sinne der Erfindung insbesondere Hochfrequenzwellen und/oder Mikrowellen verstanden. Geeignet sind beispielsweise Mikrowellen mit einer Frequenz von 2,45 GHz.

Eine entsprechende Vorrichtung zur Beschichtung von Werkstücken mittels plasmainduzierter chemischer Dampfphasenabscheidung, insbesondere mit dem vorstehend beschriebenen Verfahren umfaßt dazu eine Beschichtungskammer, eine Einrichtung zur Einleitung von Prozeßgas und eine Einrichtung zur Einleitung elektromagnetischer Energie in die Beschichtungskammer, wobei außerdem eine Meßeinrichtung für zumindest einen spektralen Parameter eines mittels der elektromagnetischen Energie im Prozeßgas erzeugten Plasmas, eine Kontrolleinrichtung mit welcher der Parameter mit einem Sollbereich verglichen wird, und eine Einrichtung zum Aussortieren des Werkstücks bei einer Abweichung des Parameters vom Sollbereich vorgesehen sind.

Die Messung spektraler Parameter kann gemäß einer bevorzugten Ausführungsform der Erfindung dazu verwendet werden, Lecks festzustellen. Diese Lecks können beispielsweise an der Beschichtungskammer auftreten und die Zusammensetzung des Prozeßgases und damit auch die abgeschiedene Beschichtung verändern. Ist die Beschichtungsvorrichtung gemäß einer weiteren bevorzugten Ausführungsform zur Beschichtung von Behältern, insbesondere einer Innenbeschichtung ausgebildet, wobei für die Innenbeschichtung Prozeßgas in das Innere des Behälters eingefüllt und dort ein Plasma gezündet wird, so können besonders bevorzugt mittels der Erfindung auch Lecks an den Behältern selber festgestellt werden. Auch können Lecks in der Zuleitung detektiert werden.

Die spektroskopische Messung der Leckrate ist äußerst empfindlich und schnell, da sie während des Beschichtungsprozesses selbst erfolgen kann. Defekte Behälter können dann in einfacher Weise durch Feststellung einer Abweichung vom Sollbereich aussortiert werden, ohne, daß ein vorheriger oder nachträglicher aufwendiger Lecktest durchgeführt werden muß.

Besonders geeignet zur Messung der Leckrate ist die Intensität einer Emissions- oder Absorptionslinie von Stickstoff als spektraler Parameter. Stickstoff ist im allgemeinen auch im Restgas einer evakuierten oder teilevakuierten Beschichtungskammer vorhanden. Tritt Stickstoff aus der Umgebung in den Beschichtungsbereich mit dem Prozeßgas ein, so entstehen oder verstärken sich aufgrund des erhöhten Stickstoffanteils im Plasma auch dessen Emissions- und Absorptionslinien, was spektroskopisch sehr einfach und mit hoher Empfindlichkeit festgestellt werden kann, da in der Prozeßgasatmosphäre enthaltener Stickstoff bei hinreichender Konzentration sogar mit bloßem Auge anhand einer Verfärbung des Plasmas zu erkennen ist.

Die Detektion von Lecks ist dann besonders leicht, wenn ein Prozeßgas ohne stickstoffhaltige Komponenten verwendet wird. In diesem Fall reicht es aus, die -im Idealfall ganz fehlende- Intensität einer Stickstoff-Emissionslinie, wie etwa die N*-Linie bei 745 nm mit einem Schwellwert zu vergleichen. Auch bei einem stickstoffhaltigen Prozessgas, wie etwa ein HMDSN-haltiges Gemisch (HMDSN="Hexamethyldisilazan") kann aber eine Leckdetektion durch Messung der Intensität einer Emissionslinie von Stickstoff durch eine Intensitätsmessung vorgenommen werden.

Für das Herstellen einer Barrierebeschichtung kann ein Prozeßgas mit einer siliziumhaltigen Komponente verwendet und eine Siliziumoxidschicht abgeschieden werden. Bei vielen Materialien der Werkstücke, wie etwa von Kunststoff bietet es sich zusätzlich an, eine Haftvermittlerschicht und darauf die Barriereschicht mittels plasmainduzierter chemischer Dampfphasenabscheidung abzuscheiden, um die Haltbarkeit der Barrierebeschichtung zu erhöhen.

Neben einer Verwendung des gemessenen spektralen Parameters zur Kontrolle des Beschichtungsprozesses und/oder der Werkstücke, um fehlerhafte Werkstücke aussortieren zu können, kann auch wenigstens ein weiterer Parameter des Beschichtungsprozesses unter Verwendung des zumindest einen gemessenen spektralen Parameters geregelt werden. Gedacht ist dabei insbesondere an zumindest einen der Parameter

- Zusammensetzung des Prozeßgases ,
- Druck des Prozeßgases,
- Leistung der elektromagnetischen Energie
- Pulsdauer der elektromagnetischen Energie,
- Taktverhältnis der elektromagnetischen Energie. Beispielsweise kann der Prozeßgasdruck und/oder die Mikrowellenleistung erhöht werden, wenn die gemessene Intensität einer Emissionslinie des Plasmas zu schwach ist.

Eine weitere besonders bevorzugte Ausführungsform der Erfindung sieht außerdem vor, daß gepulste elektromagnetische Energie zur Erzeugung eines gepulsten Plasmas in die Beschichtungskammer mittels einer entsprechenden Einrichtung eingeleitet wird. Die gepulste Plasmaerzeugung dieses sogenannten PICVD-Verfahrens (PICVD="Plasmaimpuls-induzierte chemische Dampfphasenabscheidung") bietet gegenüber kontinuierlichen Beschichtungsverfahren einige signifikante Vorteile. So können hohe Leistungen eingespeist werden, wobei aufgrund der Pulspausen gleichzeitig erhöhte Temperaturbelastungen vermieden werden. Außerdem kann in den Pulspausen das verbrauchte Prozeßgas abgeführt werden, so daß eine Anreicherung unerwünschter Reaktionsprodukte vermieden wird. Damit wird die Herstellung besonders reiner und definierter Beschichtungen ermöglicht. Gleichzeitig bietet es sich dabei an, sich auch Informationen aus der Messung des zeitlichen Verlaufs spektraler Parameter zu Nutze zu machen, um den Prozeßablauf zu überwachen und auch Werkstücke mit fehlerhafter Beschichtung auszusortieren. So kann vorteilhaft der zeitliche Verlauf der Lichtemission einer Emissionslinie eines Bestandteils des Prozeßgases während eines Pulses gemessen werden, um-Informationen über den Beschichtungsprozeß zu gewinnen. Auch hier können dann von einer Kontrolleinrichtung ermittelte Abweichungen von Sollbereichen, die sich negativ auf die Produktqualität auswirken, dazu verwendet werden, die betreffenden Werkstücke auszusortieren.

Ein Beispiel ist wieder die Verwendung eines Prozeßgases mit einer siliziumhaltigen Komponente, wie HMDSO oder HMDSN, wobei dann der zeitliche Verlauf einer SiO-Emissionslinie gemessen wird.

Alternativ oder zusätzlich kann auch die Einhüllende des Intensitätsverlaufs der gepulsten Emission einer Emissionslinie als spektraler Parameter gemessen werden, um Rückschlüsse auf die Beschichtungsqualität oder eventuelle fehlerhafte Werkstücke ziehen zu können.

Die Intensität einer Emissionslinie kann auch dazu verwendet werden, die tatsächlich gezündeten Pulse zu zählen. Es muß nämlich nicht bei jeder Zuführung eines Pulses elektromagnetischer Energie zu einer Plasmazündung und damit einer Abscheidung von Material kommen. Werden aber anhand der Emission einer oder mehrere Emissionslinien die tatsächlichen Plasmapulse gezählt, kann mit hoher Genauigkeit unter anderem auf die abgeschiedene Schichtdicke geschlossen werden. Es bietet sich daher auch an, die Zählung der Plasmapulse zur Prozeßsteuerung zu verwenden. So kann insbesondere jeweils so lange beschichtet werden, bis eine vorgegebene Anzahl von Pulsen anhand der Intensität einer Emissionslinie gezählt wurde. Danach kann die Zuführung von elektromagnetischen Pulsen gestoppt werden und entweder nach Wechsel des Prozeßgases eine weitere Schicht aufzubringen, oder das nächste Werkstück einzuführen.

Die Pulsanzahl einer Emissionslinie kann überdies auch als spektraler Parameter herangezogen werden, der bei einer Abweichung von einem Sollbereich einen Beschichtungs- und/oder Werkstückfehler anzeigt, um derartige Werkstücke nach oder während der Beschichtung auszusortieren. Eine Möglichkeit ist etwa, die Anzahl tatsächlicher Plasmapulse pro Zeiteinheit festzustellen. Zündet etwa dann ein Plasma zu selten, so kann dies ein Indiz für eine fehlerhafte Beschichtung sein. Derartige Fehler sind beispielsweise denkbar, wenn bei der Beschichtung von Behältern ein Behälter verformt ist, so daß sich eine veränderte Kavität für die Mikrowellen oder Hochfrequenzwellen ergibt. Derartige Verformungen können auch beispielsweise anhand der Pulsform einer Emissionslinie bei der Aufzeichnung des zeitlichen Intensitätsverlaufs festgestellt werden. Die Pulsform einer Emissionslinie ist insbesondere auch charakteristisch für die jeweilige Prozeßgaszusammensetzung, so daß sich anhand der Pulsform auch auf die Zusammensetzung der abgeschiedenen Beschichtung schließen läßt und damit Werkstücke mit fehlerhafter Beschichtung aussortiert werden können.

Ebenso kann gemäß einer Variante auch anhand der Intensität einer Emissionslinie oder eines Spektralbereichs die Anzahl der Plasmapulse mit der Anzahl der ebenfalls gezählten elektromagnetischen Pulse verglichen werden, um die Anzahl von Fehlzündungen, beziehungsweise von Zündaussetzern zu ermitteln und bei Überschreiten eines Schwellwerts, beipielsweise eines Verhältnisses von Fehlzündungen zu elektromagnetischen Pulsen eine fehlerhafte Beschichtung zu erkennen und das betreffende Werkstück auszusortieren. Anders ausgedrückt erfolgt dabei eine Aussortierung, wenn die Abweichung der Anzahl von Plasmapulsen von der Anzahl elektromagnetischer Pulse einen Schwellwert überschreitet.

Die Erfindung sieht auch vor, alternativ oder zusätzlich zur Intensität einer Emissionslinie die Intensität einer Absorptionslinie zu messen. Dies ermöglicht beispielsweise bei der PICVD-Beschichtung auch Messungen in den Pulspausen.

Außerdem besteht vorteilhaft die Möglichkeit, zumindest einen spektraler Parameter des Absorptions- oder Emissionsspektrums des Prozeßabgases zu messen. Damit lassen sich etwa auch anhand der entstandenen Reaktionsprodukte Rückschlüsse auf die Beschichtungsqualität ziehen.

Die Erfindung gestattet nicht nur eine Senkung der Poduktionskosten durch eine besonders einfache und effektive Prozeßkontrolle, auch die erfindungsgemäß herstellbaren Erzeugnisse zeichnen sich durch eine besonders hohe Produktqualität aus.

So kann durch das erfindungsgemäße Aussortieren anhand der Messung eines oder mehrerer spektraler Parameter in einer Charge beschichteter Behälter eine um 90%, bevorzugt um 95% reduzierte Leckrate gegenüber einer unbeschichteten Charge von Behältern erreicht werden.

Selbstverständlich können auch andere Fehler bei einzelnen Werkstücken einer Charge reduziert werden, wie etwa fehlerhafte Beschichtungen mit abweichender Schichtzusammensetzung.

Auch erlaubt die Kontrolle des Beschichtungsprozesses anhand spektraler Parameter eine besonders geringe Variation der Schichtdicke der abgeschiedenen Beschichtung, die zwischen den Werkstücken innerhalb der Charge höchstens 5% beträgt. Damit ist im Sinne der Erfindung nicht gemeint, daß die Schichtdicke entlang der beschichteten Oberfläche des Werkstücks nur um diesen Betrag variiert, sondern, daß die Schichtdicke an einer vergleichbaren Stelle, wie beispielsweise der Mitte des Flaschenbodens von Werkstück zu Werkstück nur um diesen geringen Betrag schwankt.

Führen etwa eine zu große Anzahl von Zündaussetzern zu einer zu geringen Schichtdicke, so kann durch Messsung der Plasmapulse pro Zeiteinheit dies durch die Kontrolleinrichtung erkannt und das betreffende Werkstück daraufhin aussortiert werden. Durch dieses Aussortieren werden die Schichtdickenvariationen innerhalb einer Charge demgemäß merklich reduziert.

Im folgenden wird die Erfindung anhand von Ausführungsbeispielen und unter Bezugnahme auf die Zeichnungen näher erläutert, wobei gleiche und ähnliche Elemente mit gleichen Bezugszeichen versehen sind und die Merkmale verschiedener Ausführungsbeispiele miteinander kombiniert werden können.

Es zeigen:

Fig. 1 ein Ausführungsbeispiel einer erfindungsgemäßen Vorrichtung,

Fig. 2 eine Variante des in Fig. 1 dargestellten Ausührungsbeispiels,

Fig. 3 bis 5 den zeitlichen Verlauf der SiO-Emissionslinie bei 425 nm während eines Mikrowellenpulses für drei verschiedene Flaschenformen, und

Fig. 6 bis Fig. 9 verschiedene Ausführungsformen von Meßeinrichtungen für spektrale Parameter.

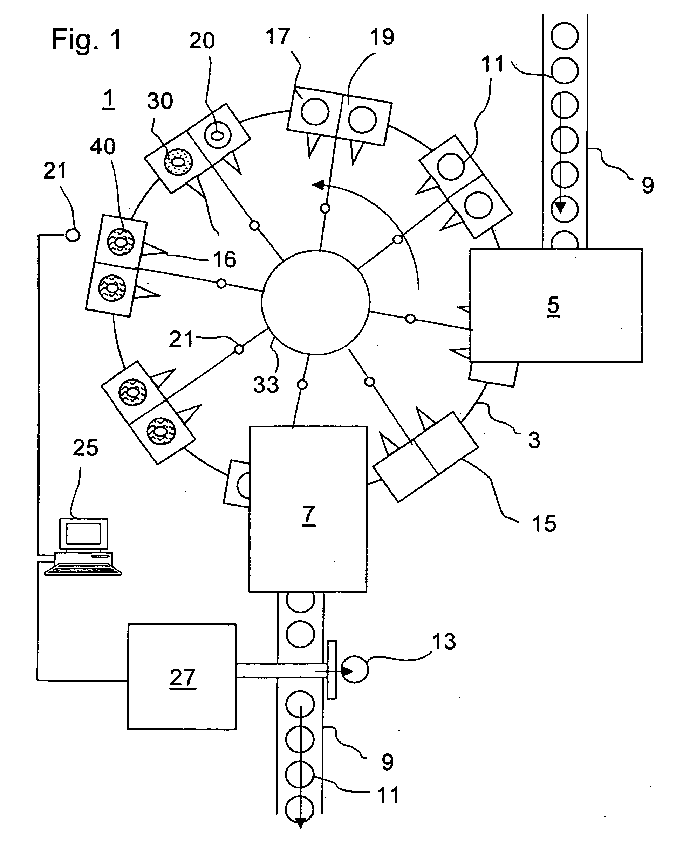

Fig. 1 zeigt schematisch ein Ausführungsbeispiel einer erfindungsgemäßen, als Ganzes mit dem Bezugszeichen 1 bezeichneten Vorrichtung zur Beschichtung von Werkstücken mittels plasmainduzierter chemischer Dampfphasenabscheidung. Die Vorrichtung 1 umfaßt eine als Rundläufer ausgebildete Transporteinrichtung 3, auf welcher Reaktoren 15 mit jeweils zwei Beschichtungskammern 17, 19 angeordnet sind und mittels der Transporteinrichtung 3 auf einem kreisförmigen Transportweg transportiert werden. Weiterhin ist eine Beladeeinrichtung 9 und eine Entnahmeeinrichtung 7 vorgesehen, mit welchen die Werkstücke in die Reaktoren 15 eingesetzt, beziehungsweise aus diesen entnommen werden.

Die Vorrichtung 1 des in Fig. 1 gezeigten Ausführungsbeispiels ist für die Innenbeschichtung von Behältern, wie insbesondere von Flaschen 11 ausgebildet. Die Flaschen 11 werden mittels einer Fördereinrichtung 9 zur Beladeeinrichtung 5 transportiert und von der Beladeeinrichtung 5 in die Beschichtungskammern 17, 19 der Reaktoren 15 eingesetzt. Während der Rotation der Reaktoren 15 auf der Transporteinrichtung werden die Beschichtungskammern 17, 19 und das Behälterinnere evakuiert. Dabei wird die Umgebung der Flasche auf 10 mBar bis 50 mBar und das Flascheninnere auf einen niedrigeren Druck von unter 2 mBar abgepumpt. Zum Abpumpen ist eine Abpumpeinrichtung 33 vorgesehen, die mit den Beschichtungskammern 17, 19 verbunden ist. Bei dem in Fig. 1 gezeigten Ausführungsbeispiel ist die Abpumpeinrichtung 33 auf der Transporteinrichtung 3 angeordnet und rotiert somit ebenfalls.

Als Bestandteil einer Einrichtung zur Einleitung von Prozeßgas werden Lanzen 20 in die Flaschen 11 eingeführt und Prozeßgas 30 eingelassen.

Durch Mikrowellenköpfe 16 der Reaktoren 15 wird elektromagnetische Energie in Form von gepulsten elektromagnetischen Wellen, beispielsweise mit einer Frequenz von 2,45 GHz in die Beschichtungskammern 17, 19 eingeleitet, wodurch in der Prozeßgasatmosphäre im Flascheninneren ein Plasma 40 erzeugt wird. Außerdem ist eine Meßeinrichtung 21 vorgesehen, welche einen spektralen Parameter des Emissionsspektrums aufnimmt. Der oder die gemessenen Parameter werden von einer Kontrolleinrichtung, beispielsweise wie in Fig. 1 gezeigt, einen Rechner 25 verarbeitet und mit Sollwerten verglichen. Liegt der spektrale Parameter innerhalb eines vorbestimmten Sollbereichs, so wird der Beschichtungsprozess.und das Werkstück als ordnungsgemäß erkannt. Alternativ oder zusätzlich besteht neben der Messung der Intensität von Emissionslinien des Plasmas auch die Möglichkeit, Absorptionslinien des Absorptionsspektrums aufzunehmen, etwa, um die Zusammensetzung des Prozeßgases in den Pulspausen zu kontrollieren.

Zusätzlich können auch, wie in Fig. 1 gezeigt, mit dem Rechner 25 verbundene Meßeinrichtungen 21 in den Zuleitungen zur Pumpeinrichtung 33 angeordnet sein, um einen spektralen Parameter des Emissions- und/oder Absorptionsspektrums des Prozeßabgases aufzunehmen. Auf diese Weise kann auch das Prozeßabgas analysiert werden.

Die Beschichtungskammern 17, 19 der Reaktoren werden nach erfolgter Beschichtung der Flaschen belüftet und die Flaschen 11 mittels der Entnahmeeinrichtung 7 beschichteten Werkstücke 11 entnommen und auf eine weitere Fördereinrichtung 7 gesetzt.

Weicht der gemessene spektrale Parameter vom vorgegebenen Sollbereich ab, so wird die betreffende Flasche und/oder deren Beschichtung als fehlerhaft erkannt und eine fehlerhafte Flasche 13 aussortiert. Dazu ist eine Einrichtung 27 zum Aussortieren fehlerhafter Flaschen 13 vorgesehen, welche beispielsweise die jeweiligen Flaschen 13 von der Fördereinrichtung 9 entfernt. Die Einrichtung 27 ist an den Rechner 25 angeschlossen und wird vom Rechner 25 bei einer Abweichung des gemessenen spektralen Parameters vom vorgegebenen Sollbereich entsprechend angesteuert, um die fehlerhafte Flasche 13 später aus der Menge der übrigen Flaschen 11 auf der Fördereinrichtung 9 zu entfernen.

Die Meßeinrichtung 21 kann besonders bevorzugt zur Messung einer Stickstoff-Emissionslinie ausgebildet sein. Beispielsweise kann die Meßeinrichtung 21 dazu eine Photodiode mit einem optischen Filter zur Messung der N*-Linie bei 745 nm umfassen. Wird im Emissionsspektrum dann mittels der Photodiode eine N*-Linie hinreichender Intensität und damit das Vorhandensein von Stickstoff im Prozeßgas gemessen, so deutet dies auf ein Leck in der Flasche 11 hin, da der Stickstoff-Partialdruck in der Umgebung der Flasche höher als im Innenraum der Flasche ist und aus der Beschichtungskammer Stickstoff der Restgasatmosphäre in das Flascheninnere eindringt. Ein Leck in der Gaszuleitung für das Prozessgas kann so ebenfalls entdeckt werden. Das Eindringen von Stickstoff läßt sich bei hinreichender Konzentration leicht sogar mit bloßem Auge feststellen, da dann das Plasma eine orangerote Farbe annimmt .

Wird beispielsweise eine Flasche mit einem Prozessgassfluss von 1000 sccm Precursorgas beschichtet, wobei die Flasche ein Loch von 1mm Durchmesser aufweist und der Flaschenaußendruck 10 mbar beträgt, so fließt bei einer verblockten Strömung wie sie bei einer Blende auftritt ein Leckstrom von:

$$\text{Leckstrom [mbar*l/s]} = 15{,}7 \ [\text{l/s*1/cm}^2] * \text{Durchmesser}^2 * \text{Druck [mbar]}.$$

Dies sind bei oben genannten Bedingungen 1,6 mbar*1/sec (94 sccm). Eine Druckmessung müsste bereits auf 10 % genau sein, um ein derartiges Leck feststellen zu können. Dies ist jedoch technisch anspruchsvoll. Eine Spektralmessung muss lediglich zwischen dem Vorhandensein oder Nichtvorhandensein einer Stickstoff-Emissionslinie unterscheiden und kann eine Flasche mit einem solchen Leck problemlos und in einfacher Weise erkennen, so daß die Flasche sicher aussortiert werden kann.

Weitere Linien, deren Intensität zur Kontrolle des Beschichtungsvorganges geeignet sind, sind unter anderem die O*-Emissionslinien bei 367 nm und 777 nm, und die SiO-Linie bei 425 nm.

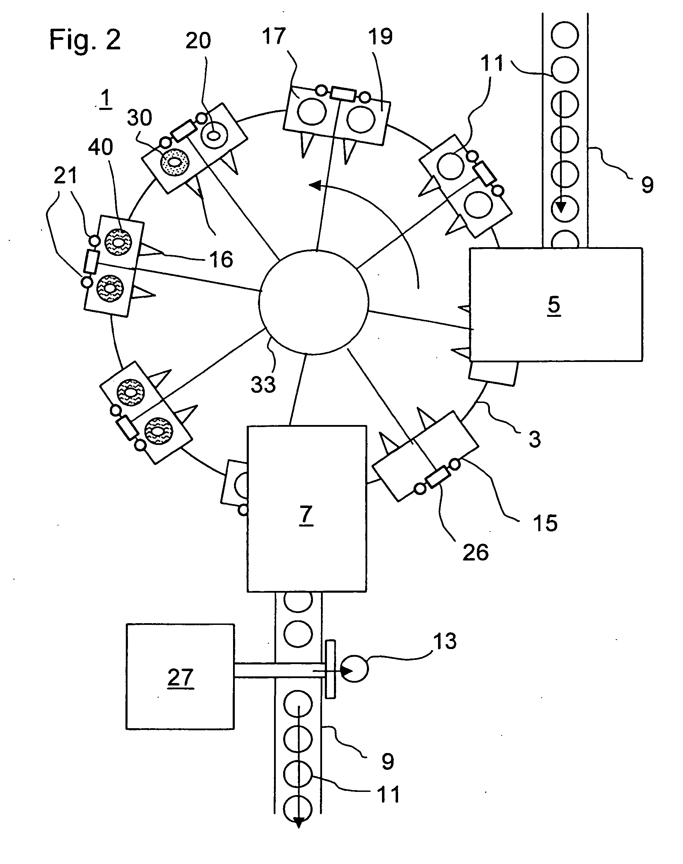

Fig. 2 zeigt eine Variante des in Fig. 1 gezeigten Ausführungsbeispiels. Bei dieser Variante sind Meßeinrichtungen 21 an jeder Beschichtungskammer 17, 19 der Reaktoren 15 angeordnet. Die Kontrolleinrichtung, mit welcher der Parameter mit einem Sollbereich verglichen wird, umfaßt bei diesem Beispiel Mikrocontroller 26 an jedem der Reaktoren 15. Ergibt ein Vergleich eines gemessenen spektralen Parameters, wie beispielsweise die Intensität der N*-Emissionslinie einen fehlerhaften Beschichtungsprozess oder ein Leck in der Flasche, so übermittelt der Mikrocontroller ein Fehlersignal an die Einrichtung 27 zum Aussortieren, woraufhin diese die fehlerhafte Flasche 13 aussortiert.

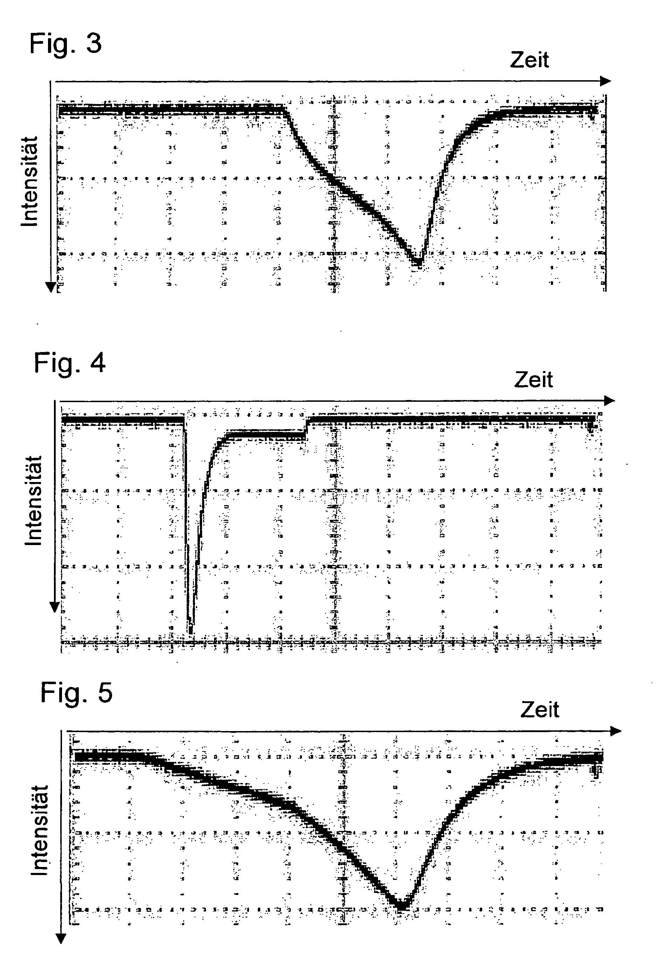

Die Fig. 3 bis Fig. 5 zeigen den gemessenen zeitlichen Verlauf der Lichtemission der SiO-Emissionslinie bei 425 nm aus dem Plasma des Prozeßgases während eines Pulses. Diese Linie tritt auf, wenn Siliziumoxid-Barriereschichten, etwa mit HMDSO und/oder HMDSN als Prozeßgas-Bestandteil durch Plasmabeschichtung abgeschieden werden.

Die deutlich unterschiedlichen Linienformen der Pulse sind charakteristisch für die jeweiligen Beschichtungsparameter. So kann aus den in den Fig. 3 bis 5 gezeigten Linienformen auf die Prozessgaszusammensetzung geschlossen werden. Dementsprechend kann auch anhand der Form der Pulse zurückgeschlossen werden, ob der Beschichtungsprozess fehlerhaft war, wenn die gemessene Pulsform von einer Sollkurve zu stark abweicht, um fehlerhafte Werkstücke auszusortieren.

Alle vorgenannten spektralen Parameter können auch vorteilhaft dazu verwendet werden, über eine Kontrolleinrichtung, wie den in Fig. 1 gezeigten Rechner 25 weitere Parameter des Beschichtungsprozesses, wie etwa den Prozeßgasdruck, die Pulsleistung oder das Taktverhältnis, also das Verhältnis von Pulsdauer zu Pulspause zu regeln.

Weitere Möglichkeiten spektraler Parameter sind die anhand der Intensität der SiO-Emissionslinie ermittelte Anzahl der Plasmapulse und die Anzahl der Plasmapulse pro Zeiteinheit. Die gemessene Anzahl der tatsächlichen Plasmapulse kann vorteilhaft dazu verwendet werden, die Dauer des Beschichtungsprozesses zu steuern. So kann insbesondere so lange beschichtet werden, bis eine vorgegebene Anzahl von Pulsen anhand der Intensität einer Emissionslinie gezählt wurde. Auf diese Weise können mit hoher Reproduzierbarkeit sehr gleichmäßige Schichtdicken innerhalb einer Charge beschichteter Werkstücke erreicht werden.

Die Messung der Anzahl der Plasmapulse pro Zeiteinheit, beziehungsweise deren Frequenz kann auch wiederum dazu verwendet werden, fehlerhafte Beschichtungen zu erkennen und fehlerhaft beschichtete Flaschen auszusortieren, etwa, wenn die Anzahl der Plasmapulse pro Zeiteinheit unter einen vorgegebenen Schwellwert fällt. Dazu kann die Kontrolleinrichtung, wie beispielsweise der Rechner 25 oder die Mikrocontroller 26 eingerichtet sein, die Anzahl Plasmapulse pro Zeiteinheit zu ermitteln. Alternativ oder zusätzlich kann die Kontrolleinrichtung auch eingerichtet sein, die Anzahl von Plasmapulsen mit der Anzahl der elektromagnetischen Pulse zu vergleichen und bei einer zu großen Abweichung ein Fehlersignal zu erzeugen, woraufhin unter Ansprechen auf das Fehlersignal die fehlerhafte Flasche 13 mittels der Einrichtung 27 aus der Fertigung herausgenommen wird.

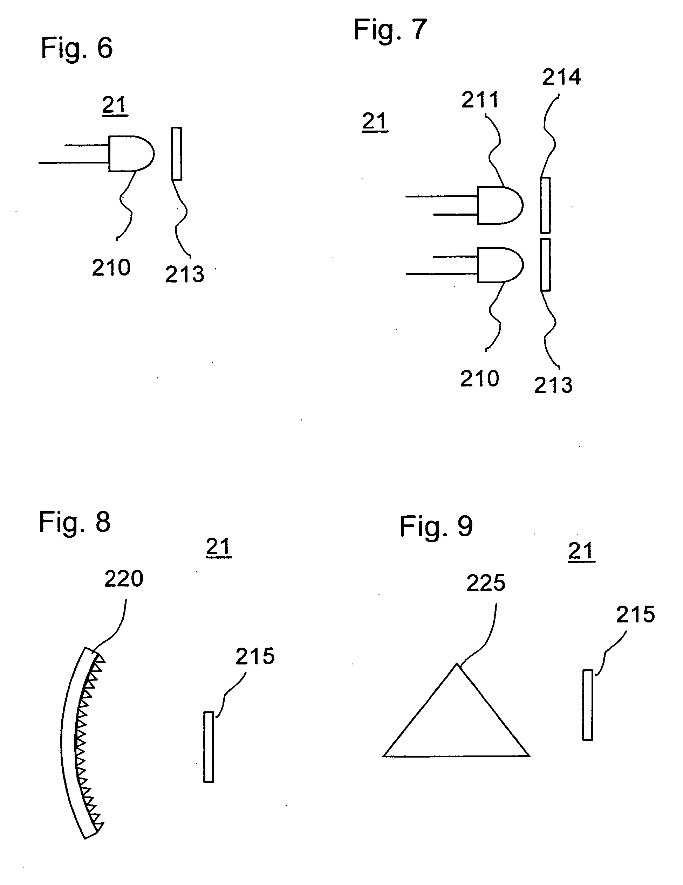

Die Fig. 6 bis Fig. 9 zeigen schematisch verschiedene mögliche Meßeinrichtungen für spektrale Parameter.

Fig. 6 zeigt eine Meßeinrichtung 21, welche eine Photodiode 210 mit vorgeschaltetem Interferenzfilter 213 umfaßt. Der Interferenzfilter kann beispielsweise für die Transmission der N*-Emissionslinie bei 745 Nanometern ausgelegt sein, so daß mit der Meßeinrichtung 21 der Stickstoffgehalt des Plasmas und damit -insbesondere bei Verwendung eines Prozeßgases ohne stickstoffhaltige Komponenten- das Vorhandensein von Lecks ermittelt werden können.

Fig. 7 zeigt eine Weiterbildung dieser Meßeinrichtung mit zwei Photodioden 210, 211, denen unterschiedliche Interferenzfilter 213, 214 vorgeschaltet sind. Die Filter 213, 214 können beispielsweise auf zwei verschiedene Emissionslinien abgestimmt sein. Insbesondere ist es aber auch möglich, den Filter 213 auf eine Emissionslinie, beispielsweise wieder die N*-Linie bei 745 nm, und den anderen Filter 214 auf einen Bereich neben dieser Linie abzustimmen, so daß mit der Photodiode 211 der Untergrund gemessen werden kann. Wird das Untergrund-Signal von dem mit der Diode 210 gemessenen Signal abgezogen, so kann die Intensität der Emissionslinie mit hoher Genauigkeit gemessen werden. Damit sind unter anderem auch Lecks bei einem stickstoffhaltigen Prozeßgas feststellbar.

Fig. 8 zeigt schematisch eine Ausführungsform einer Meßeinrichtung 21, mit welcher ganze Emissionsspektren oder Teilbereiche von Spektren gemessen werden können. Dazu umfaßt die Meßeinrichtung 21 einen CCD-Chip 215 und ein optisches Gitter 220, welches die Emissionslinien auf dem CCD-Baustein abbildet. Alternativ kann, wie Fig. 9 zeigt, anstelle eines optischen Gitters 220 auch ein Prisma 225 verwendet werden.

Es ist dem Fachmann ersichtlich, dass die Erfindung nicht auf die vorstehend beschriebenen Ausführungsformen beschränkt ist, sondern vielmehr in vielfältiger Weise variiert werden kann. Insbesondere können die Merkmale der einzelnen beispielhaften Ausführungsformen auch miteinander kombiniert werden.

## Patentansprüche

1. Vorrichtung zur Beschichtung von Werkstücken mittels plasmainduzierter chemischer Dampfphasenabscheidung, mit einer Beschichtungskammer, einer Einrichtung zur Einleitung von Prozeßgas und einer Einrichtung zur Einleitung elektromagnetischer Energie in die Beschichtungskammer, einer Meßeinrichtung für zumindest einen spektralen Parameter eines mittels der elektromagnetischen Energie im Prozeßgas erzeugten Plasmas und einer Kontrolleinrichtung mit welcher der Parameter mit einem Sollbereich verglichen wird, **gekennzeichnet durch** eine Einrichtung zum Aussortieren des Werkstücks bei einer Abweichung des Parameters vom Sollbereich.

2. Vorrichtung gemäß Anspruch 1 zur Innenbeschichtung von Behältern.

3. Vorrichtung gemäß Anspruch 2, **dadurch gekennzeichnet, daß** die Kontrolleinrichtung ausgebildet ist, anhand der Messung des spektralen Parameters festzustellen, ob der Behälter ein Leck aufweist.

4. Vorrichtung gemäß einem der vorstehenden Ansprüche, **gekennzeichnet durch** eine Meßeinrichtung zur Messung der Intensität einer Emissions- oder Absorptionslinie von Stickstoff.

5. Vorrichtung gemäß einem der vorstehenden Ansprüche, **dadurch gekennzeichnet, daß** die Einrichtung zur Einleitung elektromagnetischer Energie eine Einrichtung zur Zuführung gepulster elektromagnetischer Energie umfaßt.

6. Vorrichtung gemäß Anspruch 5, **gekennzeichnet durch** eine Meßeinrichtung zur Messung des zeitlichen Verlaufs der Lichtemission einer Emissionslinie eines Bestandteils des Prozeßgases.

7. Vorrichtung gemäß Anspruch 5 oder 6, **gekennzeichnet durch** eine Meßeinrichtung zur Messung des zeitlichen Verlaufs einer SiO-Emissionslinie gemessen wird.

8. Vorrichtung gemäß einem der Ansprüche 5 bis 7, **gekennzeichnet durch** eine Einrichtung zur Zählung von Plasmapulsen anhand der Intensität einer Emissionslinie des Plasmas.

9. Vorrichtung gemäß Anspruch 8, **gekennzeichnet**, daß die Kontrolleinrichtung eingerichtet ist, die Anzahl Plasmapulse pro Zeiteinheit zu ermitteln.

10. Vorrichtung gemäß Anspruch 8 oder 2, **dadurch gekennzeichnet, daß** Kontrolleinrichtung eingerichtet ist, die Anzahl von Plasmapulsen mit der Anzahl der elektromagnetischen Pulse zu vergleichen.

11. Vorrichtung gemäß einem der vorstehenden Ansprüche, **gekennzeichnet durch** eine Einrichtung zur Messung der Intensität einer Absorptionslinie.

12. Vorrichtung gemäß einem der vorstehenden Ansprüche, **gekennzeichnet durch** eine Einrichtung zur Messung zumindest eines spektralen Parameters des Absorptions- oder Emissionsspektrums des Prozeßabgases.

13. Vorrichtung gemäß einem der vorstehenden Ansprüche, **gekennzeichnet durch** eine Regeleinrichtung zur Regelung wenigstens eines weiteren Parameters des Beschichtungsprozesses unter Verwendung des zumindest einen gemessenen spektralen Parameters.

14. Vorrichtung gemäß Anspruch 13, **gekennzeichnet durch** eine Regeleinrichtung zur Regelung zumindest einer der Parameter

    - Zusammensetzung des Prozeßgases,
    - Druck des Prozeßgases,
    - Leistung der elektromagnetischen Energie
    - Pulsdauer der elektromagnetischen Energie,
    - Taktverhältnis der elektromagnetischen Energie

unter Verwendung des zumindest einen gemessenen spektralen Parameters.

**Claims**

1. Apparatus for coating workpieces by means of plasma-induced chemical vapour deposition, having a coating chamber, a device for introducing process gas and a device for introducing electromagnetic energy into the coating chamber, a measuring device for at least one spectral parameter of a plasma produced in the process gas by the electromagnetic energy and a monitoring device by means of which the parameter is compared with a desired range, **characterised by** a device for rejecting the workpiece if the parameter deviates from the desired range.

**2.** Apparatus as claimed in Claim 1 for coating the inside of containers.

**3.** Apparatus as claimed in Claim 2, **characterised in that** the monitoring device is formed so as to determine, using the measurement of the spectral parameter, whether the container has a leak.

**4.** Apparatus as claimed in any one of the preceding Claims, **characterised by** a measuring device for measuring the intensity of a nitrogen emission or absorption line.

**5.** Apparatus as claimed in any one of the preceding Claims, **characterised in that** the device for introducing electromagnetic energy includes a device for supplying pulsed electromagnetic energy.

**6.** Apparatus as claimed in Claim 5, **characterised by** a measuring device for measuring the temporal progression of the light emission of an emission line of a constituent of the process gas.

**7.** Apparatus as claimed in Claim 5 or 6, **characterised by** a measuring device for measuring the temporal progression of an SiO emission line is measured [*sic*].

**8.** Apparatus as claimed in any one of Claims 5 to 7, **characterised by** a device for counting plasma pulses using the intensity of an emission line of the plasma.

**9.** Apparatus as claimed in Claim 8, **characterised in that** the monitoring device is arranged to determine the number of plasma pulses per unit of time.

**10.** Apparatus as claimed in Claim 8 or 9, **characterised in that** the monitoring device is arranged to compare the number of plasma pulses with the number of electromagnetic pulses.

**11.** Apparatus as claimed in any one of the preceding Claims, **characterised by** a device for measuring the intensity of an absorption line.

**12.** Apparatus as claimed in any one of the preceding Claims, **characterised by** a device for measuring at least one spectral parameter of the absorption or emission spectrum of the process exhaust gas.

**13.** Apparatus as claimed in any one of the preceding Claims, **characterised by** a control device for controlling at least one further parameter of the coating process using the at least one measured spectral parameter.

**14.** Apparatus as claimed in Claim 13, **characterised by** a control device for controlling at least one of the following parameters:

- composition of the process gas,
- pressure of the process gas,
- power of the electromagnetic energy,
- pulse duration of the electromagnetic energy,
- pulsing ratio of the electromagnetic energy, using the at least one measured spectral parameter.

**Revendications**

**1.** Dispositif pour le revêtement de pièces au moyen d'une séparation en phase gazeuse chimique induite par plasma, comprenant une chambre de revêtement, un dispositif pour l'introduction de gaz de processus et un dispositif pour l'introduction d'énergie électromagnétique dans la chambre de revêtement, un dispositif de mesure pour au moins un paramètre spectral d'un plasma généré au moyen de l'énergie électromagnétique dans le gaz de processus et un dispositif de contrôle avec lequel le paramètre est comparé avec une plage théorique, **caractérisé par** un dispositif pour l'élimination la pièce dans le cas d'un écart du paramètre par rapport à la plage prévue.

**2.** Dispositif selon la revendication 1 pour le revêtement intérieur de récipients.

**3.** Dispositif selon la revendication 2, **caractérisé en ce que** le dispositif de contrôle est conçu pour déterminer à l'aide de la mesure du paramètre spectral si le récipient présente une fuite.

**4.** Dispositif selon l'une quelconque des revendications précédentes, **caractérisé par** un dispositif de mesure pour la mesure de l'intensité d'une ligne d'émission ou d'absorption d'azote.

**5.** Dispositif selon l'une quelconque des revendications précédentes, **caractérisé en ce que** le dispositif pour l'introduction d'énergie électromagnétique comporte un dispositif pour l'amenée d'énergie électromagnétique pulsée.

**6.** Dispositif selon la revendication 5, **caractérisé par** un dispositif de mesure pour la mesure de la variation dans le temps de l'émission lumineuse d'une ligne d'émission d'un composant du gaz de processus.

**7.** Dispositif selon la revendication 5 ou 6, **caractérisé par** un dispositif de mesure pour la mesure de la variation dans le temps d'une ligne d'émission de SiO.

**8.** Dispositif selon l'une quelconque des revendications 5 à 7, **caractérisé par** un dispositif pour le comptage d'impulsions de plasma à l'aide de l'intensité d'une ligne d'émission du plasma.

**9.** Dispositif selon la revendication 8, **caractérisé en ce que** le dispositif de contrôle est réglé pour déterminer le nombre d'impulsions de plasma par unité de temps.

**10.** Dispositif selon la revendication 8 ou 9, **caractérisé en ce que** le dispositif de contrôle est réglé pour comparer le nombre d'impulsions de plasma avec le nombre des impulsions électromagnétiques.

**11.** Dispositif selon l'une quelconque des revendications précédentes, **caractérisé par** un dispositif pour la mesure de l'intensité d'une ligne d'absorption.

**12.** Dispositif selon l'une quelconque des revendications précédentes, **caractérisé par** un dispositif pour la mesure d'au moins un paramètre spectral du spectre d'absorption ou d'émission du gaz brûlé de processus.

**13.** Dispositif selon l'une quelconque des revendications précédentes, **caractérisé par** un dispositif de réglage pour le réglage d'au moins un autre paramètre du processus de revêtement avec l'utilisation de l'au moins un paramètre spectral mesuré.

**14.** Dispositif selon la revendication 13, **caractérisé par** un dispositif de réglage pour le réglage d'au moins l'un des paramètres suivants :

- composition du gaz du processus,
- pression du gaz de processus,
- puissance de l'énergie électromagnétique,
- durée d'impulsion de l'énergie électromagnétique,
- rapport de synchronisation de l'énergie électromagnétique,

avec l'utilisation de l'au moins un paramètre spectral mesuré.

# Fig. 1

Fig. 2

Fig. 3

Zeit

Intensität

Fig. 4

Zeit

Intensität

Fig. 5

Zeit

Intensität

## Fig. 6

<u>21</u>

210    213

## Fig. 7

211    214

<u>21</u>

210    213

## Fig. 8

220    <u>21</u>

215

## Fig. 9

225    <u>21</u>

215

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6117243 A
- US 200390761 A1